# EUROPEAN PATENT APPLICATION

(11) **EP 2 524 975 A1**
(43) Date of publication of application: **21.11.2012**
(21) Application number: 10843220.4
(22) Date of filing: 29.12.2010
(51) Int. Cl.: C23C 14/34, B65G 49/06, H01L 21/02, H01L 21/205, H01L 21/677, H01L 31/04

(54) **SYSTEM OF THIN FILM FORMING APPARATUS, AND THIN FILM FORMING METHOD**

(30) Priority: 15.01.2010 JP 2010006776
(71) Applicant: Sharp Kabushiki Kaisha, Osaka-shi, Osaka 545-8522 (JP)
(72) Inventor: ZENITANI, Yoshitaka, Osaka-shi Osaka 545-8522 (JP)
(74) Representative: Müller - Hoffmann & Partner
(86) International application number: PCT/JP2010/073834
(87) International publication number: WO 2011/086868

(57) **Abstract**

A heating chamber (3) representing one of process chambers, in which a heating apparatus (20) for heating a substrate (16) and a substrate transfer apparatus (12A) for moving the substrate (16) and the heating apparatus (20) relative to each other are arranged, a ZnO sputtering chamber (4) representing one of the process chambers, in which a sputtering apparatus (26) for forming a thin film on the heated substrate (16) is arranged, and a control device (22) for controlling the substrate transfer apparatus (12A) are provided. The substrate transfer apparatus (12A) is controlled by the control device (22) such that the substrate (16) and the heating apparatus (20) in the heating chamber (3) continue to move relative to each other when transfer of the substrate (16) from the heating chamber (3) becomes impossible. According to this construction, deformation and thermal crack of the substrate can be prevented.

## Description

### TECHNICAL FIELD

The present invention relates to a thin-film formation apparatus system and a thin-film formation method.

### BACKGROUND ART

As a method of forming a thin film on a substrate, a method of heating a substrate in advance and thereafter forming a thin film with a sputtering apparatus, a plasma CVD apparatus, or the like is available. Japanese Patent Laying-Open No. 59-199036 (PTL 1) represents one of prior art documents disclosing a thin-film formation method. In the thin-film formation method described in PTL 1, heating is carried out such that a substrate and a heating source arranged in a preparatory heating chamber as opposed to each other are moved relative to each other. By carrying out heating as such, uniformity of a substrate temperature is obtained.

Japanese Patent Laying-Open No. 10-67541 (PTL 2) represents a prior art document disclosing a method of firing a substrate, with which a substrate is transferred to a heating chamber while it is carried on an upper surface of a substrate transfer apparatus such as a roller and the substrate is subjected to average heating in the heating chamber with the substrate transfer apparatus being driven to reciprocate. In the method of firing a substrate described in PTL 2, the substrate transfer apparatus in the heating chamber and a substrate transfer apparatus in a stage subsequent to the heating chamber are controlled to be driven in synchronization with each other.

Japanese Patent Laying-Open No. 2002-363744 (PTL 3) represents a prior art document disclosing a multi-layered film manufacturing apparatus including a substrate transfer mechanism for moving a substrate among chambers. In the multi-layered film manufacturing apparatus described in PTL 3, between first and third chambers each including a sputtering film deposition portion, a second chamber including a high-vacuum evacuation mechanism and a substrate heating mechanism is provided.

As the substrate is heated in the second chamber and the chamber is evacuated to high vacuum, a gas remaining from the first chamber is decreased. Thereafter, the substrate is transferred to the third chamber, so that a plurality of films are formed on the substrate while mutual diffusion of an atmospheric gas is lessened.

### CITATION LIST

### PATENT LITERATURE

PTL 1: Japanese Patent Laying-Open No. 59-199036
PTL 2: Japanese Patent Laying-Open No. 10-67541
PTL 3: Japanese Patent Laying-Open No. 2002-363744

### SUMMARY OF INVENTION

### TECHNICAL PROBLEM

In the thin-film formation methods described in Japanese Patent Laying-Open No. 59-199036, Japanese Patent Laying-Open No. 10-67541, and Japanese Patent Laying-Open No. 2002-363744, a substrate is transferred into a heating chamber by means of a substrate transfer apparatus and the substrate transfer apparatus carries out reciprocating motion in the heating chamber, so that the substrate is subjected to average heating.

In a conventional thin-film formation apparatus system, however, if abnormal stop occurs due to a trouble in an apparatus, a substrate transfer apparatus in each process chamber and a substrate transfer apparatus for moving a substrate among the process chambers stopped all together. Therefore, reciprocating operation of the substrate that has been heated in the heating chamber also stopped and it entered a stand-by state in the heating chamber while it remained stopped at a certain position. The present inventor has newly found such a problem that consequently a region close to a heating source for the substrate is soon heated and reaches a high temperature, a region different in thermal expansion is locally generated in a substrate surface, and the substrate breaks due to thermal crack.

The present invention was made in view of the above-described problems, and an object thereof is to provide a thin-film formation method and a thin-film formation apparatus system capable of lessening strain and thermal crack of a substrate by continuing operation for carrying out average heating of a substrate without stopping the operation even when abnormal stop occurs in any of process chambers.

### SOLUTION TO PROBLEM

In a first aspect of the present invention, a thin-film formation apparatus system is a thin-film formation apparatus system including a plurality of process chambers, for forming a thin film on a substrate as the substrate is processed by successively going through the process chambers. The thin-film formation apparatus system includes a heating chamber representing one of the process chambers, in which a heating apparatus for heating the substrate and a drive apparatus for moving the substrate and the heating apparatus relative to each other are arranged, a film formation chamber representing one of the process chambers, in which a film formation apparatus for forming a thin film on the heated substrate is arranged, and a control device for controlling the drive apparatus. The drive apparatus is controlled by the control device such that the substrate and the heating apparatus in the heating chamber continue to move relative to each other when transfer of the substrate from the heating chamber becomes impossible.

In one form of the present invention, the drive apparatus serves as a substrate transfer apparatus, and the substrate and the heating apparatus are moved relative to each other as a result of reciprocating operation of the substrate transfer apparatus.

In a second aspect of the present invention, a thin-film formation apparatus system is a thin-film formation apparatus system including a plurality of process chambers, for forming a thin film on a substrate as the substrate is processed by successively going through the process chambers. The thin-film formation apparatus system includes a film formation chamber representing one of the process chambers, in which a film formation apparatus for forming a thin film on the substrate is arranged, a cooling chamber representing one of the process chambers, in which a cooling apparatus for cooling the substrate on which a thin film has been formed and a drive apparatus for moving the substrate and the cooling apparatus relative to each other are arranged, and a control device for controlling the drive apparatus. The drive apparatus is controlled by the control device such that the substrate and the cooling apparatus in the cooling chamber continue to move relative to each other when transfer of the substrate from the cooling chamber becomes impossible.

In the first aspect of the present invention, a thin-film formation method is a method of forming a thin film on a substrate by successively performing a plurality of steps. The thin-film formation method includes a first step of heating the substrate while moving the substrate and a heating apparatus opposed to the substrate relative to each other, a second step of transferring the heated substrate to a thin-film formation position, and a third step of forming a thin film on the substrate transferred to the thin-film formation position. The substrate being processed in the first step and the heating apparatus are caused to continue to move relative to each other when transfer of the substrate in the second step becomes impossible.

In the second aspect of the present invention, a thin-film formation method is a method of forming a thin film on a substrate by successively performing a plurality of steps. The thin-film formation method includes a first step of transferring the substrate on which the thin film has been formed to a position of cooling, a second step of cooling the substrate while moving the substrate transferred to the position of cooling and a cooling apparatus opposed to the substrate relative to each other, and a third step of transferring the cooled substrate from the position of cooling. The substrate being processed in the second step and the cooling apparatus are caused to continue to move relative to each other when transfer of the substrate in the third step becomes impossible.

### ADVANTAGEOUS EFFECTS OF INVENTION

According to the present invention, variation in temperature in a substrate surface can be suppressed and hence strain and thermal crack of a substrate can be lessened by avoiding stop of operation for carrying out average heating of a substrate even when abnormal stop occurs in any of process chambers.

### BRIEF DESCRIPTION OF DRAWINGS

Fig. 1 is a schematic diagram showing a construction of a thin-film formation apparatus system according to a first embodiment of the present invention.
Fig. 2 is a schematic diagram showing a cross-sectional structure of a substrate loaded in the thin-film formation apparatus system according to the first embodiment, before formation of a thin film thereon.
Fig. 3 is a schematic diagram showing a cross-sectional structure of a substrate on which a thin film has been formed in the thin-film formation apparatus system according to the first embodiment, after unloading from the same.
Fig. 4 is a plan view schematically showing such a state that a substrate is loaded in a heating chamber of the thin-film formation apparatus system according to the first embodiment.
Fig. 5 is a plan view schematically showing such a state that a substrate has been arranged in the heating chamber of the thin-film formation apparatus system according to the first embodiment.
Fig. 6 is a plan view schematically showing such a state that a substrate is being loaded in a cooling chamber of the thin-film formation apparatus system according to the first embodiment.
Fig. 7 is a plan view schematically showing such a state that a substrate has been loaded in the cooling chamber of the thin-film formation apparatus system according to the first embodiment.
Fig. 8 is a cross-sectional view schematically showing the heating chamber and a ZnO sputtering chamber of the thin-film formation apparatus system according to the first embodiment.
Fig. 9 is a cross-sectional view schematically showing a buffer chamber and a cooling chamber of a thin-film formation apparatus system according to a second embodiment of the present invention.
Fig. 10 is a cross-sectional view schematically showing the heating chamber and the ZnO sputtering chamber of the thin-film formation apparatus system according to a third embodiment of the present invention.
Fig. 11 is a cross-sectional view schematically showing the heating chamber and the ZnO sputtering chamber of the thin-film formation apparatus system according to a fourth embodiment of the present invention.

### DESCRIPTION OF EMBODIMENTS

A thin-film formation method and a thin-film formation apparatus system according to a first embodiment of the present invention will be described hereinafter with reference to the drawings.

### (First Embodiment)

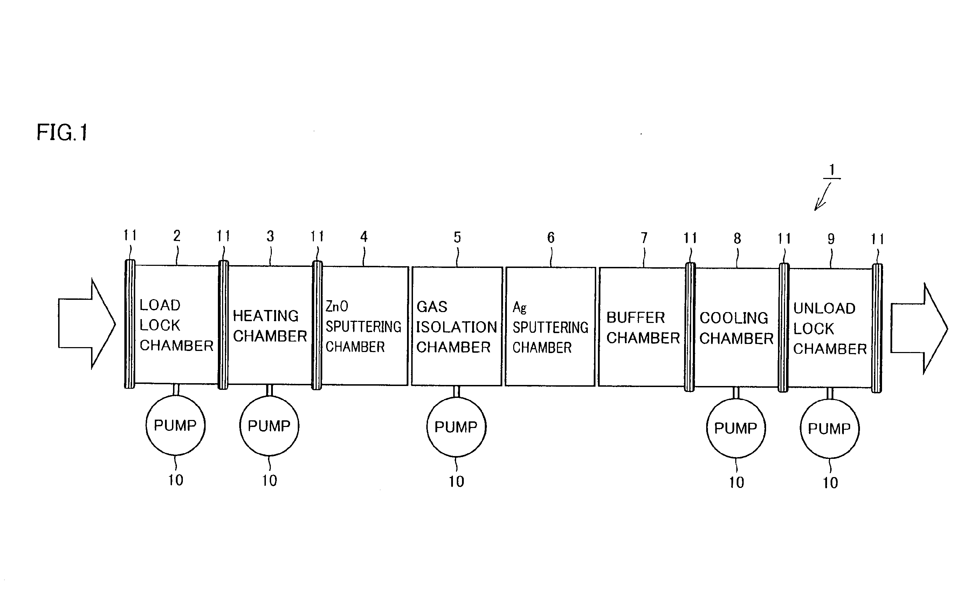

Fig. 1 is a schematic diagram showing a construction of the thin-film formation apparatus system according to the first embodiment of the present invention. In a thin-film formation apparatus system 1 in the present embodiment, a ZnO sputtering chamber and an Ag sputtering chamber each including a sputtering apparatus are shown as film formation chambers for forming a thin film on a substrate, however, an apparatus for forming a thin film is not limited to a sputtering apparatus. For example, a film formation chamber including a plasma CVD apparatus or a vapor deposition apparatus may be applicable. In addition, though a case of forming a transparent electrode and a back electrode of a thin-film solar cell will be described in the present embodiment, the present invention is not limited thereto and it is applicable to a general manufacturing process for forming a thin film.

As shown in Fig. 1, in thin-film formation apparatus system 1 according to the present embodiment, a substrate is transferred in a direction of an arrow in the figure and introduced into a load lock chamber 2. After the substrate is loaded in load lock chamber 2, a gate valve 11 on an entry side of load lock chamber 2 is closed. In this state, a pump 10 connected to load lock chamber 2 is activated and vacuum is produced in load lock chamber 2. After the inside of load lock chamber 2 reaches a degree of vacuum as high as in a heating chamber 3, gate valve 11 on a heating chamber 3 side is opened and the substrate is transferred to heating chamber 3.

In heating chamber 3, a heating apparatus for heating a substrate is arranged to oppose to a substrate. In addition, in heating chamber 3, a substrate transfer apparatus serving as a drive apparatus capable of moving the heating apparatus and the substrate relative to each other is arranged. After the substrate is loaded into heating chamber 3, it is heated by the heating apparatus to a target temperature indicated as a manufacturing condition. During heating, the substrate is caused to perform reciprocating operation by the substrate transfer apparatus and the substrate is moved relative to the heating apparatus, so that the substrate can be heated to substantially be equal in temperature in a substrate surface.

A setting temperature of the heating apparatus is set to at least a target temperature indicated as a condition for manufacturing a substrate. For example, in a case where a substrate is heated with a target being set to 100°C, the setting temperature of the heating apparatus is set to a temperature not lower than 100°C and not higher than 500°C. As the setting temperature of the heating apparatus is set higher than the target temperature, a time period required for heating the substrate to the target temperature can be shortened. The above case is a case where a setting temperature of the heating apparatus is fixed, however, a substrate temperature may be monitored at any time with a not-shown temperature measurement instrument and the setting temperature of the heating apparatus may be varied at any time in accordance with the measured substrate temperature.

After heating of the substrate ends, the substrate is transferred to a ZnO sputtering chamber 4 by the substrate transfer apparatus. In ZnO sputtering chamber 4, a ZnO transparent conductive layer is stacked on an upper surface of the substrate. Though a transparent conductive layer is formed of ZnO in the present embodiment, alternatively, the transparent conductive layer may be formed by using a transparent conductive film of SnO₂ ITO, or the like.

The substrate after ZnO is stacked is transferred to a gas isolation chamber 5 by the substrate transfer apparatus. Gas isolation chamber 5 is an atmosphere isolation chamber for preventing an oxygen gas from flowing from ZnO sputtering chamber 4 into an Ag sputtering chamber 6. Vacuum is produced in gas isolation chamber 5 by pump 10 connected to gas isolation chamber 5 and the oxygen gas is prevented from flowing therein.

The substrate is transferred from gas isolation chamber 5 to Ag sputtering chamber 6 by the substrate transfer apparatus. In Ag sputtering chamber 6, an Ag metal layer is formed on a surface of the substrate to thereby provide a back electrode. Though Ag is employed as a material for the metal layer in the present embodiment, for example, a metal material such as Al may alternatively be employed.

The substrate on which the back electrode is formed is transferred to a buffer chamber 7 by the substrate transfer apparatus. Process chambers from ZnO sputtering chamber 4 to buffer chamber 7 are film formation chambers. The substrate in a stand-by state in buffer chamber 7 is transferred to a cooling chamber 8 by the substrate transfer apparatus. After the substrate is loaded in cooling chamber 8, gate valve 11 on a buffer chamber 7 side is closed.

In cooling chamber 8, a cooling apparatus for cooling the substrate is arranged to oppose to the substrate. During cooling, the substrate is caused to perform reciprocating operation by the substrate transfer apparatus and the substrate is moved relative to the cooling apparatus, so that the substrate can be cooled while a temperature in a substrate surface is kept substantially equal. Cooling is carried out until an unloadable temperature set in advance is attained, at which it can be determined that no problem will arise in terms of safety or quality even though the substrate is unloaded.

For example, control is carried out such that a substrate temperature during cooling is monitored at any time with a not-shown temperature measurement instrument and at the time point when the substrate is cooled to a temperature not higher than 90°C set in advance as the unloadable temperature, the substrate is unloaded. Alternatively, a time period for cooling required for reaching the unloadable temperature may be derived in advance by conducting prior experiments or the like under each manufacturing condition and each cooling time period derived from experimental results above may be selected as appropriate in accordance with a condition for manufacturing a substrate to be processed. In this case, it is not necessary to monitor a substrate temperature.

The substrate after cooling is transferred to an unload lock chamber 9 by the substrate transfer apparatus. In unload lock chamber 9, by purging with an atmosphere or such an inert gas as N₂, a pressure is set from a vacuum pressure to an atmospheric pressure. After unload lock chamber 9 is set to an atmospheric pressure, gate valve 11 on an unloading side is opened, the substrate is unloaded from the apparatus, and the process is completed.

As described above, a substrate is loaded in thin-film formation apparatus system 1 and processed successively in each process chamber. Throughput of the apparatus system is improved by processing different substrates in parallel in respective process chambers. In addition, the thin-film formation apparatus system includes such a computer control device as a not-shown process controller, and the control device controls operation of each process chamber and the substrate transfer apparatus.

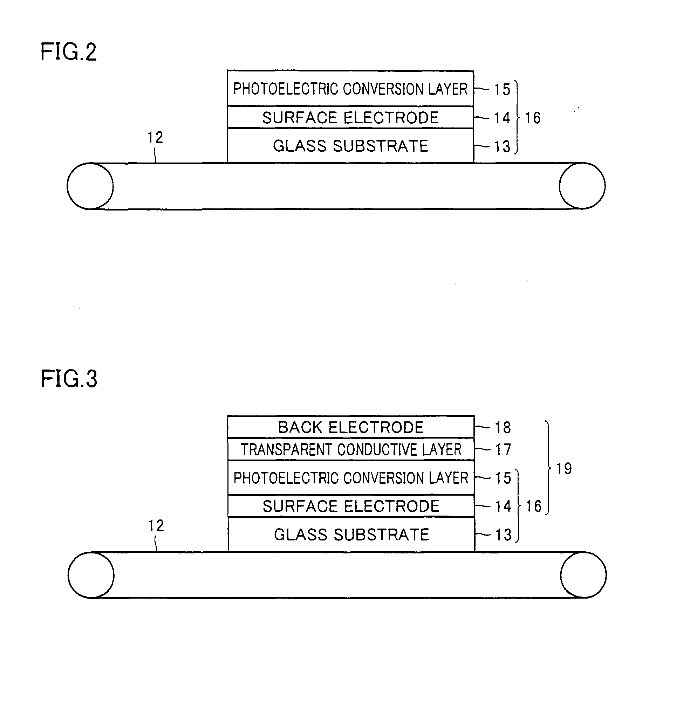

Fig. 2 is a schematic diagram showing a cross-sectional structure of a substrate loaded in the thin-film formation apparatus system according to the present embodiment, before formation of a thin film thereon. Fig. 3 is a schematic diagram showing a cross-sectional structure of a substrate on which a thin film has been formed in the thin-film formation apparatus system according to the present embodiment, after unloading from the same.

As shown in Fig. 2, a substrate 16 before loading into thin-film formation apparatus system 1 according to the present embodiment is transferred as being carried on a substrate transfer apparatus 12. In the present embodiment, a belt-type substrate transfer conveyor is adopted as substrate transfer apparatus 12, however, alternatively, a roller transfer or air-float substrate transfer apparatus may be adopted. Alternatively, a construction may be such that a substrate is transferred by a robot capable of holding and transferring a substrate. Substrate 16 is in such a state that a surface electrode 14 and a photoelectric conversion layer 15 have been formed on an upper surface of a glass substrate 13.

As shown in Fig. 3, when a substrate is unloaded by substrate transfer apparatus 12 after a thin film is formed thereon in thin-film formation apparatus system 1, a transparent conductive layer 17 and a back electrode 18 that are conductive material layers have been formed on an upper surface of substrate 16.

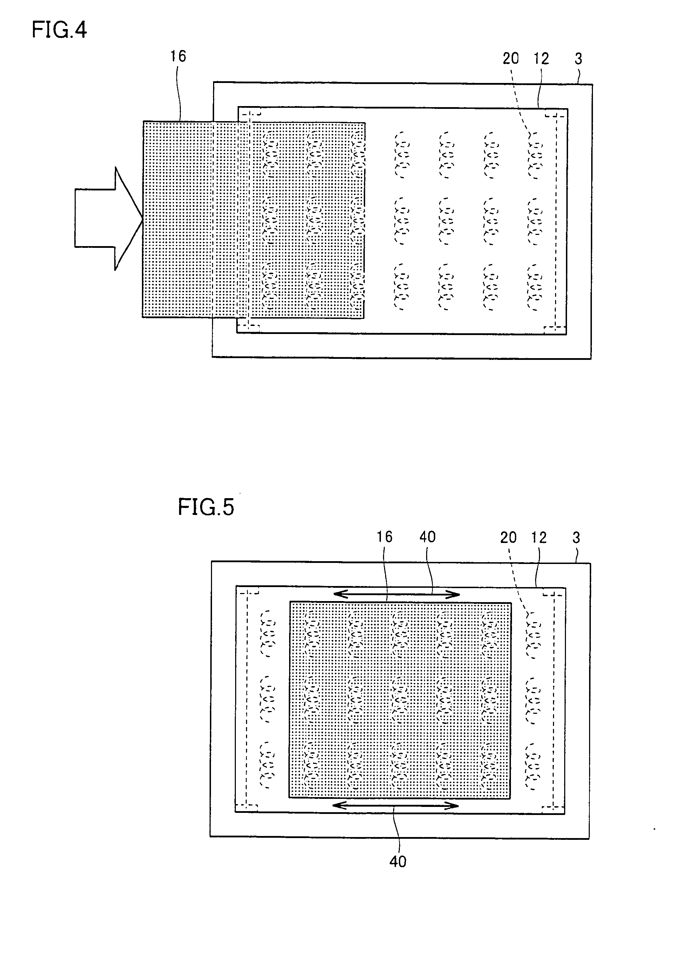

Fig. 4 is a plan view schematically showing such a state that a substrate is being loaded in the heating chamber of the thin-film formation apparatus system according to the present embodiment. Fig. 5 is a plan view schematically showing such a state that a substrate has been arranged in the heating chamber of the thin-film formation apparatus system according to the present embodiment.

As shown in Fig. 4, substrate 16 is transferred in a direction of an arrow in the figure and loaded in heating chamber 3. It is noted that Fig. 4 does not show load lock chamber 2. As shown in Fig. 4, in heating chamber 3, substrate 16 is loaded into heating chamber 3 while it is carried on the upper surface of substrate transfer apparatus 12.

A plurality of heating sources 20 included in a heating apparatus are arranged below substrate transfer apparatus 12, as aligned and opposed to the substrate. A heating wire, a ceramic heater, a quartz heating pipe, or the like can be employed as heating source 20. In addition to such a construction that heating sources 20 are installed as aligned discretely in the heating chamber, a plate heater or the like which is an integrated plate-shaped heat generator obtained by sandwiching heating sources between plates of metal or the like may be employed.

As shown in Fig. 5, substrate 16 loaded into heating chamber 3 is heated by heating source 20. Since a position in a plane of substrate 16 closer to heating source 20 is heated sooner to a high temperature, a temperature in the substrate surface varies if positions of substrate 16 and arranged heating source 20 relative to each other are constant.

In order to lessen variation in temperature in the substrate surface, during heating, substrate transfer apparatus 12 is caused to carry out reciprocating drive 40 to thereby vary positions of substrate 16 and heating source 20 relative to each other. Thus, substrate 16 can be heated while a temperature thereof is kept substantially uniform (average heating). Temperature distribution in a plane of substrate 16 is thus kept substantially equal and damage to substrate 16 caused by difference in local thermal expansion can be lessened.

Though a construction in which substrate 16 is subjected to average heating through reciprocating operation and drive of conveyor-type substrate transfer apparatus 12 representing a drive apparatus is shown in the present embodiment, alternatively, such a construction that a mechanism for shaking a stage carrying substrate 16 is provided as a drive apparatus may be employed.

Though an orientation of reciprocating operation during heating is in parallel to a direction of transfer of a substrate in the present embodiment, a not-shown mechanism reciprocating or shaking in a direction orthogonal to the direction of transfer of a substrate may be provided in substrate transfer apparatus 12, and during heating, substrate 16 may be caused to reciprocate or shake in the orientation orthogonal to the direction of transfer of the substrate. Alternatively, the substrate may be caused to reciprocate or shake in both of the direction in parallel to the direction of transfer of the substrate and the direction orthogonal thereto.

As the heating chamber is thus provided with a drive apparatus capable of moving the heating source and the substrate relative to each other, heating can be carried out while a temperature in the substrate surface is kept substantially uniform.

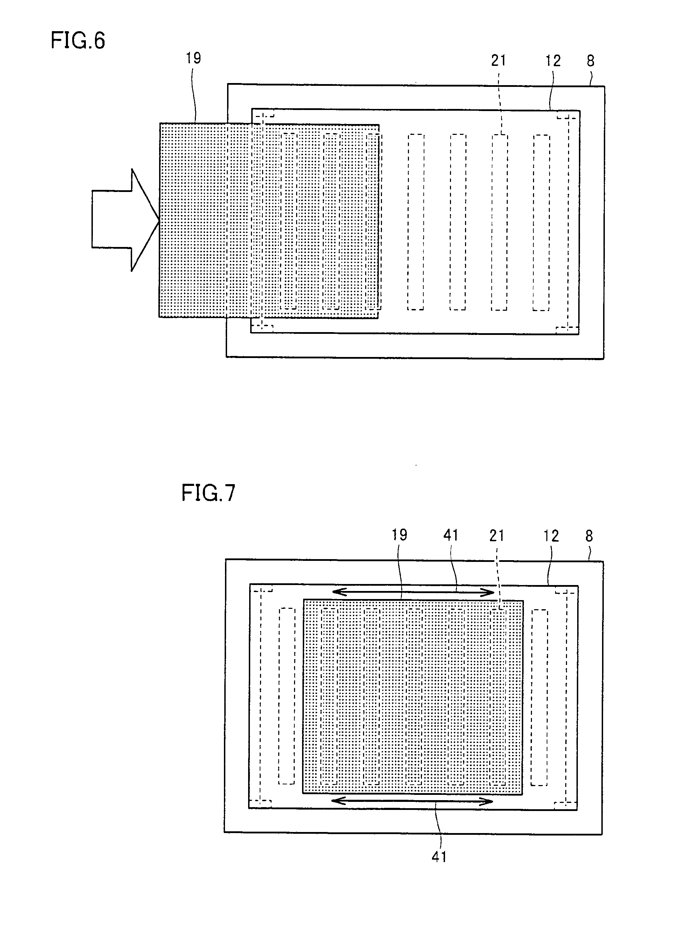

Fig. 6 is a plan view schematically showing such a state that a substrate is being loaded in the cooling chamber of the thin-film formation apparatus system according to the present embodiment. Fig. 7 is a plan view schematically showing such a state that a substrate has been loaded in the cooling chamber of the thin-film formation apparatus system according to the present embodiment.

As shown in Fig. 6, a substrate 19 is transferred in a direction of an arrow in the figure and loaded in cooling chamber 8. It is noted that Fig. 6 does not show buffer chamber 7. As shown in Fig. 6, in cooling chamber 8, substrate 19 is loaded into cooling chamber 8 while it is carried on the upper surface of substrate transfer apparatus 12. A cooling pipe 21 serving as a cooling source implementing a cooling apparatus, through which such a coolant as a cooling liquid, a cooling gas, or the like flows, is arranged below substrate transfer apparatus 12, as aligned and opposed to substrate 19.

Though cooling pipe 21 is employed as the cooling source in the present embodiment, an electronic cooling element or the like may be employed as the cooling source. In addition to such a construction that cooling sources are installed as aligned discretely in the cooling chamber, a cooling plate or the like which is an integrated plate-shaped cooler obtained by sandwiching cooling sources between plates of metal or the like may be employed.

As shown in Fig. 7, substrate 19 loaded into cooling chamber 8 is cooled by cooling pipe 21. Since a position in a plane of substrate 19 closer to cooling pipe 21 is cooled sooner, a temperature in the substrate surface varies if positions of substrate 19 and cooling pipe 21 relative to each other are constant.

In order to lessen variation in temperature in the substrate surface, during cooling, substrate transfer apparatus 12 serving as a drive apparatus is caused to carry out reciprocating drive 41 to thereby vary positions of substrate 19 and cooling pipe 21 relative to each other. Thus, substrate 19 can be cooled while a temperature in its plane is kept substantially uniform (average heating). A temperature in a plane of substrate 19 is thus kept substantially equal and damage to substrate 19 caused by difference in local heat shrinkage can be lessened.

Though an orientation of reciprocating operation during cooling is in parallel to the direction of transfer of a substrate in the present embodiment, a not-shown mechanism reciprocating or shaking in the direction orthogonal to the direction of transfer of a substrate may be provided in substrate transfer apparatus 12, and during cooling, substrate 19 may be caused to reciprocate or shake in an orientation orthogonal to the direction of transfer of the substrate. Alternatively, the substrate may be caused to reciprocate or shake in both of the direction in parallel to the direction of transfer of the substrate and the direction orthogonal thereto.

As the cooling chamber is thus provided with a drive apparatus capable of moving the cooling source and the substrate relative to each other, cooling can be carried out while a temperature in the substrate surface is kept substantially uniform.

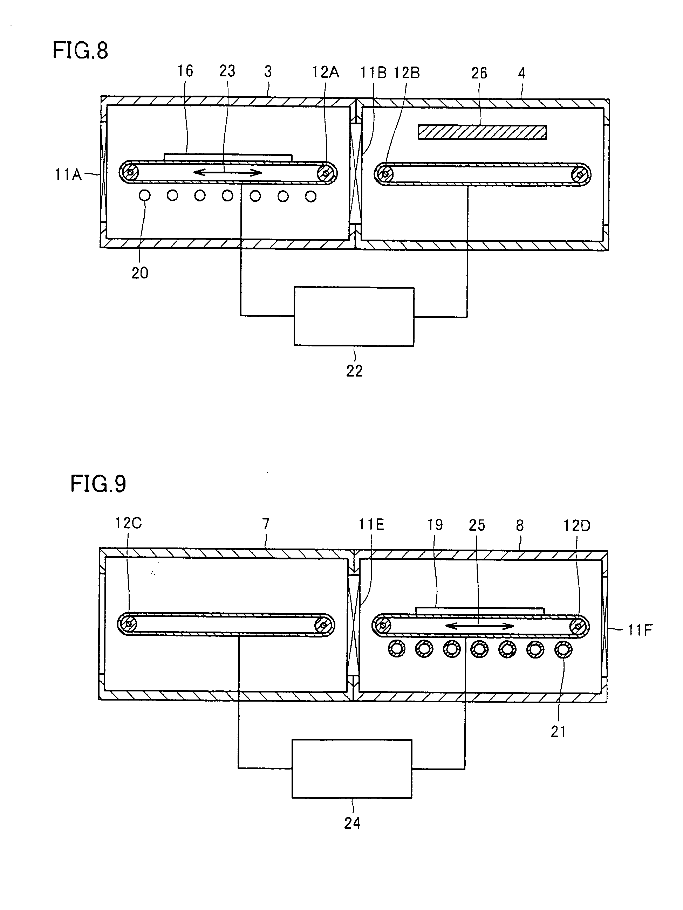

Fig. 8 is a cross-sectional view schematically showing the heating chamber and the ZnO sputtering chamber of the thin-film formation apparatus system according to the present embodiment. As shown in Fig. 8, as described above, a substrate transfer apparatus 12A serving as a drive apparatus is arranged in heating chamber 3 and substrate 16 is carried on its upper surface. Heating source 20 is arranged below substrate transfer apparatus 12A. A gate valve 11 A is provided toward the front of heating chamber 3 and a gate valve 11B is provided between heating chamber 3 and ZnO sputtering chamber 4.

A substrate transfer apparatus 12B is arranged in ZnO sputtering chamber 4 and a sputtering apparatus 26 is arranged above substrate transfer apparatus 12B. To substrate transfer apparatus 12A and substrate transfer apparatus 12B, control device 22 for controlling operation thereof is connected.

After heating of substrate 16 ends in heating chamber 3, gate valve 11B is opened and substrate transfer apparatus 12A and substrate transfer apparatus 12B are driven in synchronization with each other, so that substrate 16 is transferred from heating chamber 3 to a thin-film formation position in ZnO sputtering chamber 4. After the substrate is transferred to ZnO sputtering chamber 4, gate valve 11B is closed and transparent conductive layer 17 is formed on the upper surface of substrate 16 by sputtering apparatus 26.

While a process is performed in ZnO sputtering chamber 4, different substrate 16 loaded in next can be heated in heating chamber 3. During this heating, substrate transfer apparatus 12A carries out reciprocating drive 23.

In a conventional thin-film formation apparatus system, for example, if abnormal stop occurs in ZnO sputtering chamber 4 due to a trouble in an apparatus, substrate transfer apparatus 12B and substrate transfer apparatus 12A stopped all together. Therefore, reciprocating operation of substrate 16 that has been heated in heating chamber 3 also stopped and the substrate was heated by heating source 20 while it remained stopped at a certain position. Consequently, in some cases, a region closer to heating source 20 in the plane of substrate 16 was soon locally heated and a region different in thermal expansion in the substrate surface was locally generated, and strain or thermal crack occurred in substrate 16.

In addition, also in a case where a heating source is turned off at the time when a trouble occurs, decrease in temperature of the heating source itself takes time and therefore, until the temperature of the heating source lowers, a rate of temperature lowering in substrate 16 is different depending on a distance from a heating source, which has led to a non-uniform temperature in a plane of substrate 16 and strain or thermal crack in substrate 16.

In thin-film formation apparatus system 1 according to the present embodiment, control device 22 is provided to control substrate transfer apparatus 12A of a conveyor type serving as a drive apparatus, so that when abnormal stop occurs in ZnO sputtering chamber 4, substrate transfer apparatus 12B is stopped whereas reciprocating drive of substrate transfer apparatus 12A is continued. With control as such, substrate 16 in heating chamber 3 is heated while it is moved relative to heating source 20 and hence a temperature in a plane of substrate 16 can be kept substantially equal. Consequently, temperature variation in substrate 16 can be suppressed and strain or thermal crack of substrate 19 due to temperature variation can be lessened.

Though a case where abnormal stop occurs in ZnO sputtering chamber 4 has been described in the present embodiment, control is carried out such that, at whichever position such a trouble as stop of transfer may occur in each process chamber constituting the thin-film formation apparatus system, control device 22 causes substrate transfer apparatus 12A in heating chamber 3 to continue reciprocating drive. Though heating source 20 is arranged below substrate 16 with substrate transfer apparatus 12A lying therebetween, heating source 20 may be arranged above substrate 16 or above and below substrate 16.

A thin-film formation method and a thin-film formation apparatus system according to a second embodiment of the present invention will be described hereinafter with reference to the drawings.

### (Second Embodiment)

Fig. 9 is a cross-sectional view schematically showing the buffer chamber and the cooling chamber of the thin-film formation apparatus system according to the second embodiment of the present invention. As shown in Fig. 9, a substrate transfer apparatus 12C for transferring substrate 19 is arranged in buffer chamber 7. A gate valve 11E is provided between buffer chamber 7 and cooling chamber 8.

As described above, a substrate transfer apparatus 12D serving as a drive apparatus is arranged in cooling chamber 8 and substrate 19 is carried on an upper surface thereof. Cooling pipe 21 is arranged below substrate transfer apparatus 12D. A gate valve 11F is provided in the rear of cooling chamber 8. To substrate transfer apparatus 12C and substrate transfer apparatus 12D, a control device 24 for controlling operation thereof is connected.

After cooling of substrate 19 ends in cooling chamber 8, gate valve 11F opens and substrate transfer apparatus 12D is driven, so that substrate 19 is transferred from cooling chamber 8. Here, another substrate 19 that has been in a stand-by state in buffer chamber 7 is transferred into cooling chamber 8 as substrate transfer apparatus 12C and substrate transfer apparatus 12D are driven. While substrate 19 is cooled in cooling chamber 8, substrate transfer apparatus 12D carries out reciprocating drive 25.

In a conventional thin-film formation apparatus system, if abnormal stop occurs in buffer chamber 7, substrate transfer apparatus 12C and substrate transfer apparatus 12D stopped all together. Therefore, reciprocating operation of substrate 19 that has been cooled in cooling chamber 8 also stopped and the substrate was cooled by cooling pipe 21 while it remained stopped at a certain position. Consequently, in some cases, substrate 19 was locally cooled soon and a region different in heat shrinkage was locally generated in a substrate surface, and strain or warp occurred.

In addition, also in a case where a cooling source is turned off at the time when a trouble occurs, increase in temperature of the cooling source itself takes time and therefore, until the temperature of the cooling source increases, a rate of temperature increase in substrate 19 is different depending on a distance from a cooling source, which has led to a non-uniform temperature in a plane of substrate 19 and strain or warp in substrate 19.

In thin-film formation apparatus system 1 according to the present embodiment, control device 24 is provided to control substrate transfer apparatus 12D serving as a drive apparatus, so that when abnormal stop occurs in buffer chamber 7, substrate transfer apparatus 12C is stopped whereas reciprocating drive of substrate transfer apparatus 12D is continued. With control as such, substrate 19 in cooling chamber 8 can continue to move relative to cooling pipe 21, and hence a temperature in a plane of substrate 19 can be kept substantially equal. Consequently, temperature variation in substrate 19 can be suppressed and strain or warp of substrate 19 due to temperature variation can be lessened.

Though a case where abnormal stop occurs in buffer chamber 7 has been described in the present embodiment, control is carried out such that, at whichever position such a trouble as stop of transfer may occur in each process chamber constituting the thin-film formation apparatus system, control device 24 causes substrate transfer apparatus 12D in cooling chamber 8 to continue reciprocating drive.

In the present embodiment, though the cooling source is arranged below substrate 19 with substrate transfer apparatus 12D lying therebetween, the cooling source may be arranged above substrate 19 or above and below substrate 19. Since the thin-film formation apparatus system according to the present embodiment is otherwise the same as in the first embodiment, description will not be repeated.

A thin-film formation method and a thin-film formation apparatus system according to a third embodiment of the present invention will be described hereinafter with reference to the drawings.

### (Third Embodiment)

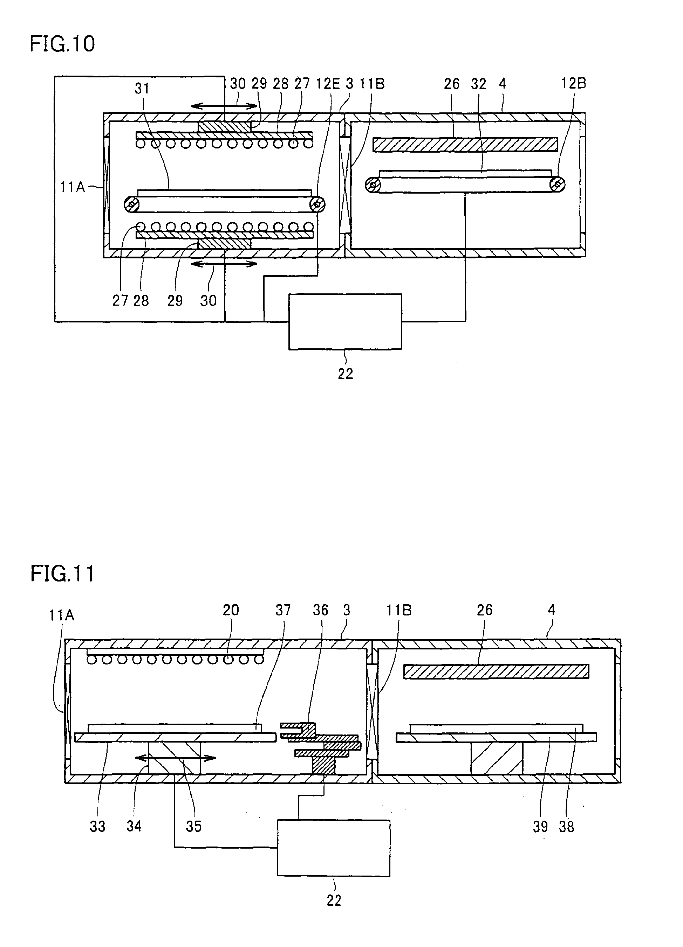

Fig. 10 is a cross-sectional view schematically showing the heating chamber and the ZnO sputtering chamber of the thin-film formation apparatus system according to the third embodiment of the present invention. As shown in Fig. 10, a substrate transfer apparatus 12E is arranged in heating chamber 3 and a substrate 31 is carried on an upper surface thereof. Heating sources 27 are arranged above and below substrate transfer apparatus 12E. A plurality of heating sources 27 are integrated, with a plate 28 being attached thereto. Gate valve 11A is provided toward the front of heating chamber 3 and gate valve 11 B is provided between heating chamber 3 and ZnO sputtering chamber 4. Substrate transfer apparatus 12B is arranged in ZnO sputtering chamber 4 and sputtering apparatus 26 is arranged above substrate transfer apparatus 12B.

Heating source 27 is installed in heating chamber 3 with a drive apparatus 29 being connected thereto so that it can shake in any direction. Fig. 10 shows such a construction that upper heating sources 27 are integrated as one set and lower heating sources 27 are integrated as one set and each set is shaken by single drive apparatus 29. The construction, however, may be such that heating sources 27 are not integrated but they are installed for respective ones of a plurality of different drive apparatuses. To drive apparatus 29, substrate transfer apparatus 12E, and substrate transfer apparatus 12B, control device 22 for controlling operation thereof is connected.

While a substrate 32 is processed in ZnO sputtering chamber 4, different substrate 31 loaded in next can be heated in heating chamber 3. During this heating, heating sources 27 are caused to perform shaking operation 30 by drive apparatus 29 and thus average heating is performed.

When abnormal stop occurs, control device 22 carries out control such that substrate transfer apparatus 12E and substrate transfer apparatus 12B are stopped but shaking operation 30 by drive apparatus 29 is continued. With control as such, substrate 31 in heating chamber 3 is heated while it is moved relative to heating source 27, and a temperature in the plane of substrate 31 can be kept substantially equal. Consequently, temperature variation in substrate 31 can be suppressed and strain and thermal crack of substrate 31 due to temperature variation can be lessened.

Though a case where abnormal stop occurs in ZnO sputtering chamber 4 has been described in the present embodiment, control device 22 carries out control such that, at whichever position such a trouble as stop of transfer may occur in each process chamber constituting the thin-film formation apparatus system, shaking operation 30 by drive apparatus 29 in heating chamber 3 is continued.

Though the third embodiment of the present invention in connection with heating chamber 3 has been described above with reference to Fig. 10, the same embodiment can clearly be applied also to the cooling chamber, and therefore drawings and description in connection with the cooling chamber are not provided. Since the thin-film formation apparatus system according to the present embodiment is otherwise the same as in the first embodiment, description will not be repeated.

A thin-film formation method and a thin-film formation apparatus system according to a fourth embodiment of the present invention will be described hereinafter with reference to the drawings.

### (Fourth Embodiment)

Fig. 11 is a cross-sectional view schematically showing the heating chamber and the ZnO sputtering chamber of the thin-film formation apparatus system according to the fourth embodiment of the present invention. As shown in Fig. 11, a stage 33 on which a substrate is carried and an arm 36 serving as a substrate transfer apparatus are arranged in heating chamber 3, and a substrate 37 is carried on an upper surface of stage 33. Heating source 20 is installed above stage 33. Gate valve 11A is provided toward the front of heating chamber 3 and gate valve 11B is provided between heating chamber 3 and ZnO sputtering chamber 4. A stage 39 is installed in ZnO sputtering chamber 4 and sputtering apparatus 26 is arranged above the stage.

Stage 33 in heating chamber 3 is provided with a drive apparatus 34 allowing stage 33 to shake in any direction. In addition, to drive apparatus 34 and arm 36, control device 22 for controlling operation thereof is connected.

While a substrate 38 is processed in ZnO sputtering chamber 4, different substrate 37 loaded in next can be heated in heating chamber 3. During this heating, drive apparatus 34 causes stage 33 to perform shaking operation 35 and thus average heating is performed.

When abnormal stop occurs in ZnO sputtering chamber 4, control device 22 carries out control such that arm 36 is stopped but reciprocating drive of drive apparatus 34 is continued. With control as such, substrate 37 in heating chamber 3 is heated while it is moved relative to heating source 20 and a temperature in the plane of substrate 37 can be kept substantially equal. Consequently, temperature variation in substrate 37 can be suppressed and strain and thermal crack of substrate 37 due to temperature variation can be lessened.

Though a case where abnormal stop occurs in ZnO sputtering chamber 4 has been described in the present embodiment, control device 22 carries out control such that, at whichever position such a trouble as stop of transfer may occur in each process chamber constituting the thin-film formation apparatus system, shaking operation 35 by drive apparatus 34 in heating chamber 3 is continued.

Though the fourth embodiment of the present invention in connection with heating chamber 3 has been described above with reference to Fig. 11, the same embodiment can clearly be applied also to the cooling chamber, and therefore drawings and description in connection with the cooling chamber are not provided. Since the thin-film formation apparatus system according to the present embodiment is otherwise the same as in the first embodiment, description will not be repeated.

As shown in the embodiment above, even when abnormal stop occurs in any of process chambers constituting the thin-film formation apparatus system, control is carried out such that reciprocating or shaking operation of a substrate or the heating (cooling) apparatus for carrying out average heating of the substrate does not stop but is continued. Thus, strain and thermal crack of the substrate can be lessened, a downtime of the thin-film formation apparatus system can be reduced, and availability of the apparatus can be improved.

A control device shown in each example can also be implemented by separately adding new control hardware or adding a program to a not-shown process controller for controlling the overall thin-film formation apparatus system.

Factors for stop of an average heating operation in the conventional thin-film formation apparatus system include not only abnormal stop due to a trouble in the apparatus but also stop of unloading of a substrate due to a trouble in a manufacturing apparatus which is a next step in the thin-film formation apparatus system and/or a wait for process due to difference in process time under a manufacturing condition for each substrate, and the like. The present invention is applicable also to stop of transfer due to these various matters.

The embodiments disclosed herein are illustrative in every respect and do not constitute any basis for limitative interpretation. Therefore, the technical scope of the present invention is not to be interpreted only based on the embodiments described above, but is defined by the description in the terms of the claims. In addition, any modifications within the scope and meaning equivalent to the terms of the claims are encompassed.

### REFERENCE SIGNS LIST

1 thin-film formation apparatus system; 2 load lock chamber; 3 heating chamber; 4 ZnO sputtering chamber; 5 gas isolation chamber; 6 Ag sputtering chamber; 7 buffer chamber; 8 cooling chamber; 9 unload lock chamber; 10 pump; 11 gate valve; 12 substrate transfer apparatus; 13 glass substrate; 14 surface electrode; 15 photoelectric conversion layer; 16, 19, 31, 32, 37, 38 substrate; 17 transparent conductive layer; 38 back electrode; 20 heating source; 21 cooling pipe; 22, 24 control device; 23, 25, 40, 41 reciprocating drive; 26 sputtering apparatus; 27 heating source; 28 plate; 29, 34 drive apparatus; 30, 35 shaking operation; 33, 39 stage; and 36 arm.

## Claims

1. A thin-film formation apparatus system (1) including a plurality of process chambers, for forming a thin film on a substrate (16) as the substrate (16) is processed by successively going through said process chambers, comprising:
a heating chamber (3) representing one of said process chambers, in which a heating apparatus (20) for heating the substrate (16) and a drive apparatus for moving the substrate (16) and said heating apparatus (20) relative to each other are arranged;
a film formation chamber (4, 6) representing one of said process chambers, in which a film formation apparatus (26) for forming a thin film on the heated substrate (16) is arranged; and
a control device (22) for controlling said drive apparatus,
said drive apparatus being controlled by said control device (22) such that the substrate (16) and said heating apparatus (20) in said heating chamber (3) continue to move relative to each other when transfer of the substrate (16) from said heating chamber (3) becomes impossible.

2. The thin-film formation apparatus system (1) according to claim 1, wherein said drive apparatus serves as a substrate transfer apparatus (12), and the substrate (16) and said heating apparatus (20) are moved relative to each other as a result of reciprocating operation of the substrate transfer apparatus (12).

3. A thin-film formation apparatus system (1) including a plurality of process chambers, for forming a thin film on a substrate (19) as the substrate (19) is processed by successively going through said process chambers, comprising:
a film formation chamber (4, 6) representing one of said process chambers, in which a film formation apparatus (26) for forming a thin film on the substrate (19) is arranged;
a cooling chamber (8) representing one of said process chambers, in which a cooling apparatus (21) for cooling the substrate (19) on which a thin film has been formed and a drive apparatus for moving the substrate (19) and said cooling apparatus (21) relative to each other are arranged; and
a control device (24) for controlling said drive apparatus,
said drive apparatus being controlled by said control device (24) such that the substrate (19) and said cooling apparatus (21) in said cooling chamber (8) continue to move relative to each other when transfer of the substrate (19) from said cooling chamber (8) becomes impossible.

4. A method of forming a thin film on a substrate (16) by successively performing a plurality of steps, comprising:
a first step of heating the substrate (16) while moving the substrate (16) and a heating apparatus (20) opposed to the substrate (16) relative to each other;
a second step of transferring the heated substrate (16) to a thin-film formation position; and
a third step of forming a thin film on the substrate (16) transferred to said thin-film formation position, wherein
the substrate (16) being processed in said first step and said heating apparatus (20) are caused to continue to move relative to each other when transfer of the substrate (16) in said second step becomes impossible.

5. A method of forming a thin film on a substrate (19) by successively performing a plurality of steps, comprising:
a first step of transferring the substrate (19) on which the thin film has been formed to a position of cooling;
a second step of cooling the substrate (19) while moving the substrate (19) transferred to said position of cooling and a cooling apparatus (21) opposed to the substrate (19) relative to each other; and
a third step of transferring the cooled substrate (19) from said position of cooling, wherein
the substrate (19) being processed in said second step and said cooling apparatus (21) are caused to continue to move relative to each other when transfer of the substrate (19) in said third step becomes impossible.
